Europäisches Patentamt

European Patent Office

Office européen des brevets

(19)

(11) Publication number: **0 179 556 B1**

# EUROPEAN PATENT SPECIFICATION

(45) Date of publication of patent specification: **27.02.91** (51) Int. Cl.⁵: **H01L 31/0224**, H01L 31/06

(21) Application number: **85306217.2**

(22) Date of filing: **02.09.85**

(54) Improved current collection structure for photovoltaic devices.

(30) Priority: **24.09.84 US 653801**

(43) Date of publication of application:
**30.04.86 Bulletin 86/18**

(45) Publication of the grant of the patent:
**27.02.91 Bulletin 91/09**

(84) Designated Contracting States:
**CH DE FR GB IT LI NL**

(56) References cited:
**EP-A- 0 111 394**

(73) Proprietor: **ENERGY CONVERSION DEVICES, INC.**
**1675 West Maple Road**
**Troy Michigan 48084(US)**

(72) Inventor: **Nath, Prem**
**245 Prospect**
**Rochester Michigan 48063(US)**
Inventor: **Barnard, Timothy J.**
**702 Kimberly Apt. 201**
**Lake Orion Michigan 48035(US)**
Inventor: **Crea, Dominic**
**37880 Moravian**
**Mt. CLemens Michigan 48043(US)**

(74) Representative: **Jackson, Peter Arthur et al**
**Gill Jennings & Every, 53-64 Chancery Lane**
**London WC2A 1HN(GB)**

Description

Recently, considerable efforts have been made to develop processes for depositing amorphous semiconductor films over relatively large areas to produce p-i-n type devices substantially equivalent to their crystalline counterparts. The term "amorphous", as used here, includes all materials or alloys that have long range disorder, although they may have short or intermediate range order or even contain some crystalline inclusions. It is now possible to prepare by glow discharge or vapor deposition large area, thin film amorphous silicon alloys having high quality electronic properties. Suitable techniques are described in U.S. Patent Nos. 4,226,898, 4,217,374 and 4,517,223. Unlike crystalline silicon which is limited to batch processing for the manufacture of solar cells, amorphous silicon semiconductor alloys can be deposited in multiple layers over large area substrates to form solar cells in a high volume, continuous processing system. Continuous processing systems of this kind are disclosed, for example, in United States Patent Nos. 4,400,409, 4,410,558, 4,438,723 and 4,492,810. As disclosed in these patents, a substrate may be continuously advanced through a succession of deposition chambers, each of which is dedicated to the deposition of a specific semiconductor material. In making a solar cell of p-i-n type configuration, the first chamber is dedicated for depositing a p-type amorphous silicon alloy, the second chamber is dedicated for depositing an intrinsic amorphous silicon alloy, and the third chamber is dedicated for depositing an n-type amorphous silicon alloy. By making multiple passes through the succession of deposition chambers, or by providing an additional array of deposition chambers, multiple cells of various configurations may be obtained.

Current-shunting defects have been noted in large-area photovoltaic cells made by the processes referred to above. In order to manufacture large area amorphous semiconductor photovoltaic devices economically, it is necessary to reduce the number of or to eliminate the effects of shunt defects. In addition, it is desirable to collect the current generated by large-area solar cells uniformly over the area of the cell.

A photovoltaic device according to the invention comprises an electrically conducting substrate, a semiconductor body deposited on the substrate, a transparent, electrically conducting current collecting layer disposed on the semiconductor body and a grid structure in electrical contact with the current collecting layer for collecting and conducting current generated by the device, the grid structure including a busbar electrically interconnected to a plurality of current collecting grid fingers characterised in that the grid fingers are resistively interconnected to the busbar to have a current carrying capacity not exceeding about five times the amount of current that can be produced by the area of device from which a grid finger collects current.

In one embodiment, a plurality of grid fingers are resistively connected to a busbar to limit current flow. Typically, the current flow is limited to no more than the amount of current that can be generated in an area for which a particular grid finger collects current, meaning excessive current from a defect is suppressed. Alternatively, the grid fingers may be electrically connected to the busbar with a destructible or fuse-type connection that opens when an excessive current flows through it. Usually, for each grid finger, the amount of current considered excessive is slightly greater than the maximum amount of current that can be generated in the area for which the particular grid finger collects current. Another embodiment includes a bus grid having grid fingers and a busbar that is electrically insulated from the conductive layer to reduce the probability of collecting current through a defect. In another embodiment of the invention, a buffered bus grid structure, i.e. one on which the grid fingers are unbranched and are directly coupled to the major busbar of the photovoltaic device, is used to overcome the effects of shunt defects.

Figure 1 is a fragmentary, cross-sectional view of a tandem or cascade photovoltaic device comprising a plurality of p-i-n type cells, each layer of cells formed from an amorphous, semiconductor alloy.

Figure 2 is a cross-sectional, perspective view of the photovoltaic device of Figure 1.

Figure 3 is a top view of the photovoltaic device of Figure 1.

Figure 4 is a top view of a portion of a photovoltaic device similar to the photovoltaic device of Figure 3, but having a defect in it.

Figure 5 is a fragmentary, cross-sectional view of a tandem or cascade photovoltaic device comprising a plurality of p-i-n type cells, each layer of the cells formed from an amorphous, semiconductor alloy, the photovoltaic device having a conductive layer in accordance with one embodiment of the invention.

Figure 6 is a top view of a portion of a photovoltaic device similar to the photovoltaic device shown in Figure 5 but having a short circuit defect.

Figure 7 is a top view of a portion of a photovoltaic device that includes a bus grid structure in accordance with one embodiment of the invention.

Figure 8 is a top view of a portion of a photovoltaic device that includes a bus grid structure in accordance with another embodiment of the invention.

Figure 9 is a top view of a portion of a photovoltaic device that includes a buffered bus grid structure in accordance with one embodiment of the invention.

Figure 10 is a top plan view of a portion of a photovoltaic device that includes another embodiment of a buffered bus grid structure in accordance with the invention.

Figure 11 is a top plan view of a portion of a photovoltaic device that includes another embodiment of a bus grid structure in accordance with the invention.

Figure 12 is a top plan view of a portion of a photovoltaic device that includes another embodiment of a bus grid structure in accordance with the invention.

Figure 13 is a cross-sectional, perspective view of a photovoltaic device in accordance with the invention.

Figure 14 is a diagrammatic illustration of the relationship of power output of photovoltaic devices versus center-to-center grid finger spacing for different conductive layer resistances and constant grid finger width.

Figure 15 is a diagrammatic illustration of the relationship of power output of photovoltaic devices versus center-to-center grid finger spacing for different grid finger widths at a constant conductive layer resistance.

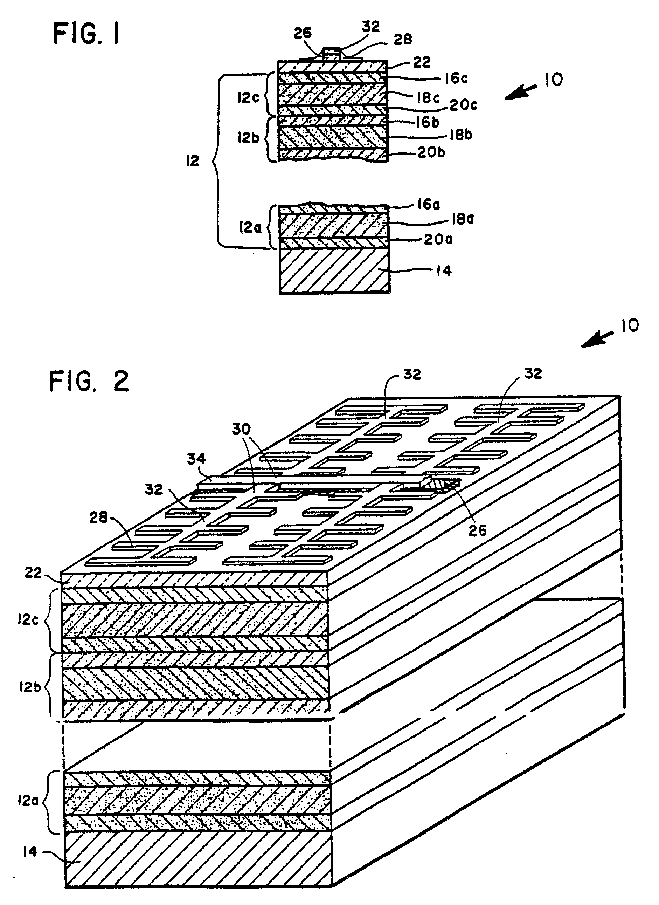

Figure 1 shows a tandem or cascade photovoltaic device 10. Device 10 includes a semiconductor body 12 including a plurality of p-i-n photovoltaic cells 12a, 12b, and 12c. Adjacent cell 12a is an electrically conducting substrate 14 which may be transparent or formed with foil having a metallic surface. Certain applications may require a thin oxide layer and/or a series of base contracts be deposited prior to the application of the amorphous material. In this description the term substrate includes not only a flexible film, but also any elements added to it by preliminary processing. Substrate 14 may be formed of stainless steel, aluminum, tantalum, molybdenum, or chrome, or an insulating material such as glass, with a conductive coating.

Each of cells 12a, 12b, and 12c includes an amorphous alloy body containing at least a silicon alloy. Each of the alloy bodies includes an n-type region or layer (16a, 16b and 16c); an intrinsic region or layer (18a, 18b and 18c); and a p-type region or layer (20a, 20b and 20c). As illustrated, cell 12b is an intermediate cell and, as indicated in Figure 1, additional intermediate cells may be added. The invention is also useful for single cells.

Following the deposition of the semiconductor layers, a transparent electrically conductive layer 22, formed in a preferred embodiment of indium tin oxide, is deposited over the semiconductor material. An electrode grid or bus grid structure 24 is applied to the device to shorten the carrier path through conductive layer 22 and increase current collection efficiency.

As shown in Figure 2, a layer of insulating material 26 is interposed between conductive layer 22 and portions of bus grid structure 24. Bus grid structure 24 includes a current collecting portion, grid fingers 28, that are in electrical contact with layer 22, and a current carrying portion, a busbar structure 30, that is electrically connected to grid fingers 28 but insulated from layer 22, as illustrated in Figure 2. Busbar structure 30 includes a minor busbar 32 and a major busbar 34. Since busbar structure 30 is insulated from transparent conductive layer 22, no current can be collected by it. Therefore, if a low resistance current path defect lies near busbar structure 30, no excessive current can flow to the low resistance path through busbar structure 30. The insulation therefore reduces the performance degrading effect of such defects.

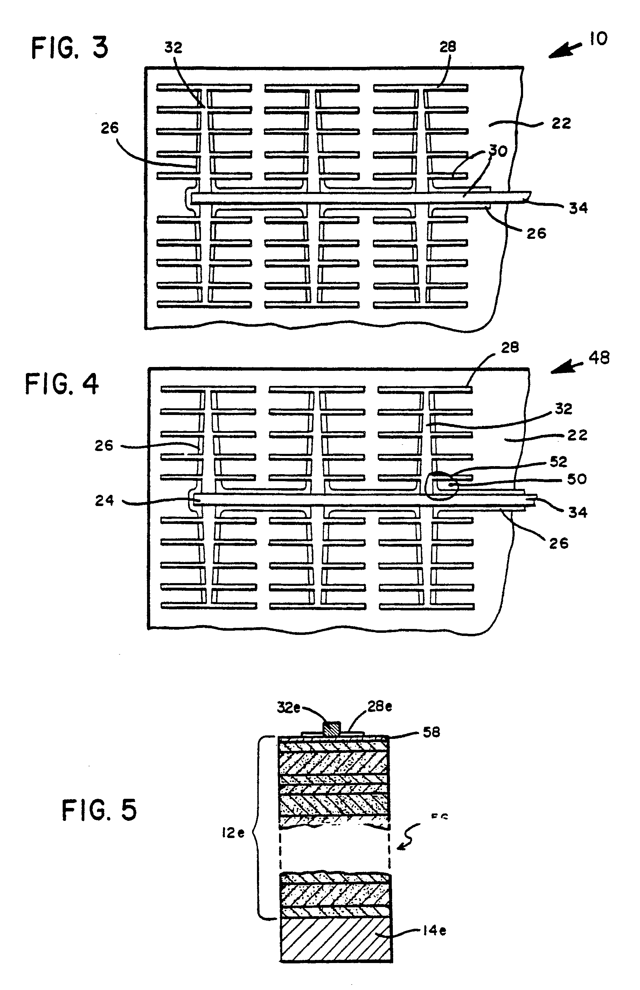

In the plan view of photovoltaic device 10 in Figure 3, it can be seen that insulating layer 26 is substantially coextensive with, but slightly wider than minor bus 32 and major bus 34. Insulating layer 26 is preferable transparent, so that only the area covered by bus grid structure 24 shades device 10 from incident light.

Insulating layer 26 may be any suitable insulating material, including an ink having a suitably high resistance, insulating carbides, natural and synthetic polymers such as acrylics, fluorocarbon polymers and silicones, ceramic materials, glasses or insulating oxides. The insulating layer may be applied by any suitable method, including silk screening, roller coating, spraying, vapor deposition or evaporation.

The improvement achieved with insulating layer 26 is illustrated in Figure 4. A photovoltaic device 48 includes a low resistance current path 50. Because layer 22 is typically very thin it has large lateral resistance so that only a limited area, enclosed by line 52, is potentially adversely affected by current path 50. That area includes part of one of grid fingers 28, minor busbar 32 and major busbar 34 lies. But low resistance current path 50 has no effect on either minor busbar 32 or major busbar 34 since they are insulated from conductive layer 22 by insulating layer 26. Some current does flow from defect 50 through the grid finger that lies in proximity of defect 50, but that current is limited by the relatively small cross-sectional area of grid finger 28. If the insulating material 26 were not present, current would flow to low resistance current path 50 through one of grid fingers 28, major busbar 34 and minor busbar 32, within the area enclosed by line 52

In Figure 5, a photovoltaic device 56 in accordance with another embodiment of the invention is illustrated. Photovoltaic device 56 is similar to photovoltaic device 10 and includes a substrate 14e, grid fingers 28e, a minor busbar 32e and a transparent conductive layer 58. Photovoltaic device 56 lacks insulating layer 26, but could include one. In contrast to device 10, conductive layer 58 has a relatively high sheet resistance that reduces the current flow to a low resistance current path in semiconductor body 12e. The high sheet resistance of conductive layer 58 is preferably at least about 300 ohms/square, and preferably about 1,000 ohms/square in contrast to the typical sheet resistance of about 50 to 100 ohms/square.

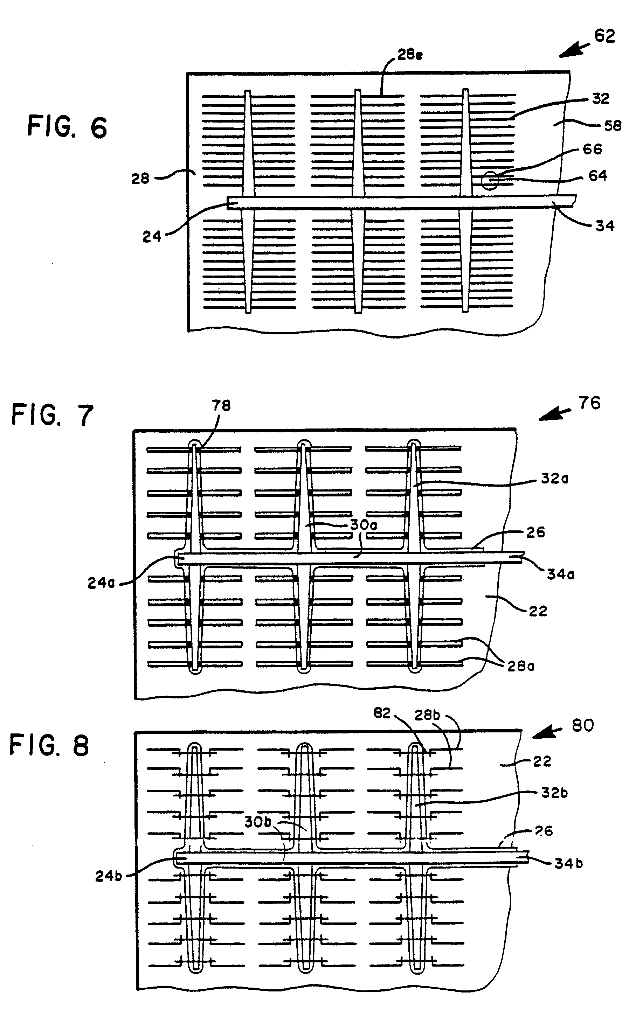

In Figure 6, a photovoltaic device 62, of similar design to photovoltaic device 56, has a conductive layer 22 having a sheet resistance of at least about 300 ohms/square. Grid fingers 28e are substantially smaller in cross-sectional area, and consequently of larger lengthwise resistance, than grid fingers of a photovoltaic device having a conventional sheet resistivity layer. As a result, when one of grid fingers 28e is in an area affected by a low resistance current path, much less current will be drawn through grid finger 28e than through a grid finger of conventional cross section. By way of illustration, a low resistance current path 64 in device 56 affects an area 66. The relatively high sheet resistance of conductive layer 58 first reduces the current flow over a conventional resistivity transparent layer and the smaller cross-sectional area of the grid finger reduces the defect current flow even more. Because of the smaller sized grid fingers and higher resistance transparent layer, photovoltaic device 62 utilizes more, but smaller, fingers than conventional photovoltaic devices.

The transparent conductive layer may comprise any material having the desired properties, namely transparency and the desired resistance. Suitable materials include, for example, various conductive metal oxide coatings such as tin oxide materials, including $SnO_2$ and $SnO_2$ doped with antimony or other elements such as cadmium, molybdenum and indium; $In_2O_3$ and $In_2O_3$ doped with tin or other elements such as cadmium, bismuth and molybdenum; or cadmium-oxygen materials such as CdO and cadmium oxide doped with tin. $In_2O_3$, $SnO_2$ and ZnO must be doped and formed in a manner to develop a large number of oxygen vacancies. As is known to those skilled in the art, the resistance of the conductive layer can be fixed as desired by controlling the thickness of the conductive layer or by controlling its composition.

A photovoltaic device 76 of Figure 7 is similar in construction to photovoltaic device 10 of Figure 1 but with a modification of its grid structure. Bus grid structure 24a includes a current collecting portion, including grid fingers 28a and a current carrying portion, including busbar structure 30a that includes minor busbar 32a and a major busbar 34a. Busbar structure 30a is insulated from transparent conductive layer 22. Each of grid fingers 28a is resistively connected to minor busbar 32a. The current carrying capability of each of grid fingers 28a is no greater than about five times the amount of photo-induced current that can be produced by the area from which each grid finger 28a collects current. Grid fingers 28a may be resistively connected to minor busbar 32a in any suitable manner. In Figure 7, each of grid fingers 28a is resistively connected to one of the minor busbars 32a by a small deposit of a resistive material.

In Figure 8, each of grid fingers 28b is resistively connected to busbar structure 30b by a strip of resistive ink. The ink may be a mixture of silver and carbon ink deposited to produce a sheet resistivity of about 70 micro-ohms/square. Such resistive connections, and even grid fingers 28b, can be conveniently deposited by screen printing.

Bus grid structures can also be deposited for example, by electroplating and vacuum deposition, such as sputtering. The entire grid may be formed by one method or by a combination of several methods.

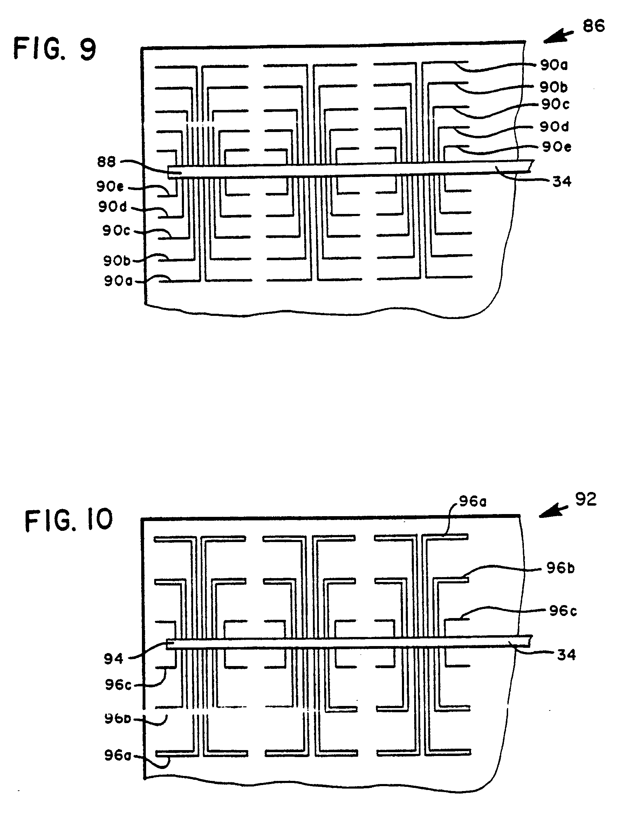

Photovoltaic device 86 of Figure 9 has no insulating layer 26, but includes a buffered electrode grid or buffered bus grid structure 88. A buffered grid is one that contains only grid fingers and a major busbar. Buffered bus grid structure 88 includes a major busbar 34 and a plurality grid fingers 90a-90e. Each of grid fingers 90a-90e is directly coupled to major busbar 34.

In Figure 10, an alternate buffered electrode grid embodiment on a photovoltaic device 92 is illustrated. Photovoltaic device 92 does not have an insulating layer 26, but has a buffered bus grid structure 94. Buffered bus grid structure 94 includes a major busbar 34 and a plurality of grid fingers 96a-96c. Each grid finger has a selected cross-sectional area so that all grid fingers have the same end to end resistance. The longer grid fingers are wider and/or thicker than the shorter grid fingers. If desired, major busbar 34 could be insulated from the semiconductor body.

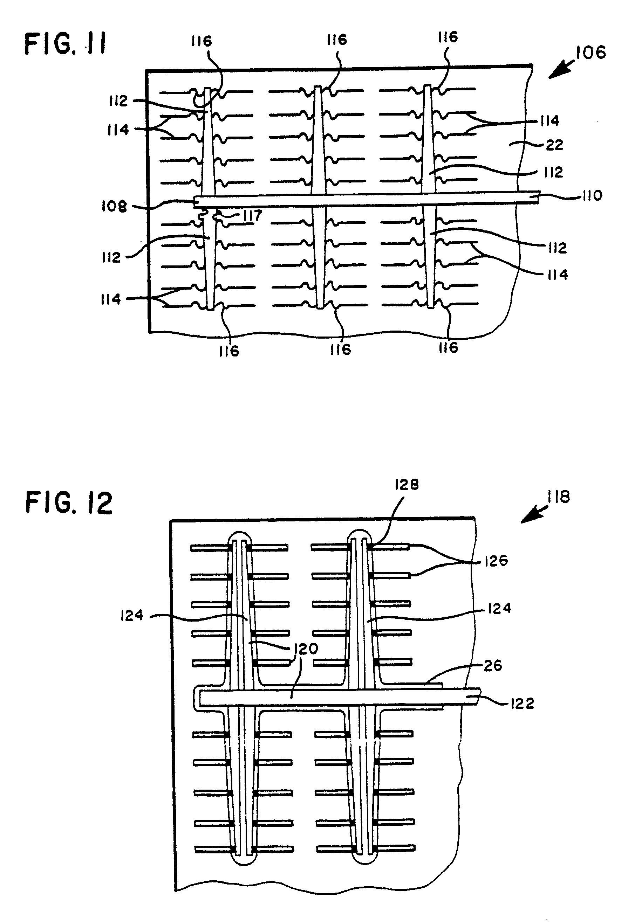

The grid structure 108 of a photovoltaic device 106 in Figure 11 includes a major busbar 110, a minor busbar 112, and a plurality of grid fingers 114 for collecting current. Each of grid fingers 114 is electrically connected to a minor busbar 112 with a destructible connection 116. When the current flowing through destructible connection 116 reaches a predetermined amount, the electrical connection opens. Usually, for each grid finger, the predetermined amount will be slightly greater (for example, about 1.2 times) than the maximum amount of current that can be produced by the area of photovoltaic device 106 for which a particular grid finger 114 collects current. Generally, destructible connection 116 will comprise fusible material, for example, tin, lead, bismuth, and alloys thereof. The thickness and cross-sectional area of the fusible material may be adjusted to open at a preselected current.

Also shown in Figure 11 is a destructible connection 117 between minor busbar 112 and major busbar 110. As with connection 116, connection 117 opens if the current reaches a predetermined amount. Again, destructible connection 117 will usually be able to conduct slightly more (about 1.2 times, for example) current than the maximum amount produced by the area of the device for which the minor busbar carries current.

In Figure 12, a photovoltaic device 118 having a bus grid structure 120 is shown. Bus grid structure 120 includes a major busbar 122, a plurality of bifurcated minor busbars 124 and a plurality of grid fingers 126. Each of grid fingers 126 is connected to its respective bifurcated minor busbar 124 with a resistive connection 128. Each of bifurcated minor busbars 124 is similar to minor busbar 32 except that bifurcated minor busbar 124 is split lengthwise into essentially equal widths. This division minimizes the amount of current that can be sent to a low resistance current path defect in the semiconductor body via a minor busbar.

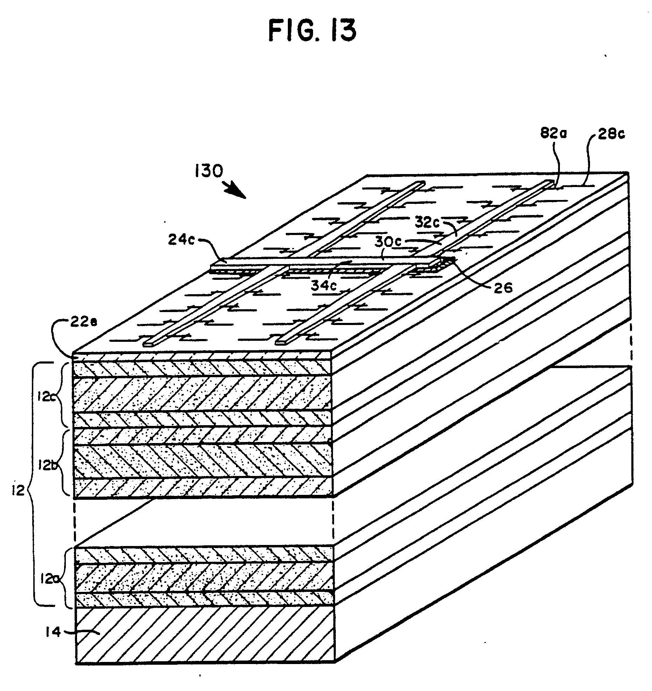

Referring to Figure 13, a photovoltaic device 130 including a semiconductor body 12 consisting of a plurality of p-i-n photovoltaic cells 12a, 12b, and 12c is shown. Cell 12a rests on a substrate 14. Over the surface of semiconductor body 12 is a transparent, conductive layer 22c over which lies an electrode grid or bus grid structure 24c that comprises a busbar structure 30c, including a minor busbar 32c and a major busbar 34c. A plurality of grid fingers 28c are connected to each of minor busbars 32c. Each of grid fingers 28c is similar to grid fingers 28b previously described with respect to Figure 10. The resistive connections of grid fingers 28c are similar to resistive connection 82 described with respect to Figure 10. As described with respect to Figures 1 and 2, a layer of insulating material 26 is disposed between conductive layer 22 and portions of bus grid structure 24c. The current carrying portion of bus grid structure 24c, busbar structure 30, is insulated from semiconductor body 12 so that no current can be conducted directly to a short or low resistance curent path through busbar structure 30c. Transparent conductive layer 22c has a relatively high resistance of at least about 300 ohms/square. This further reduces the degrading effect on the electrical performance of photovoltaic device 130 should any low resistance paths be present or should any develop.

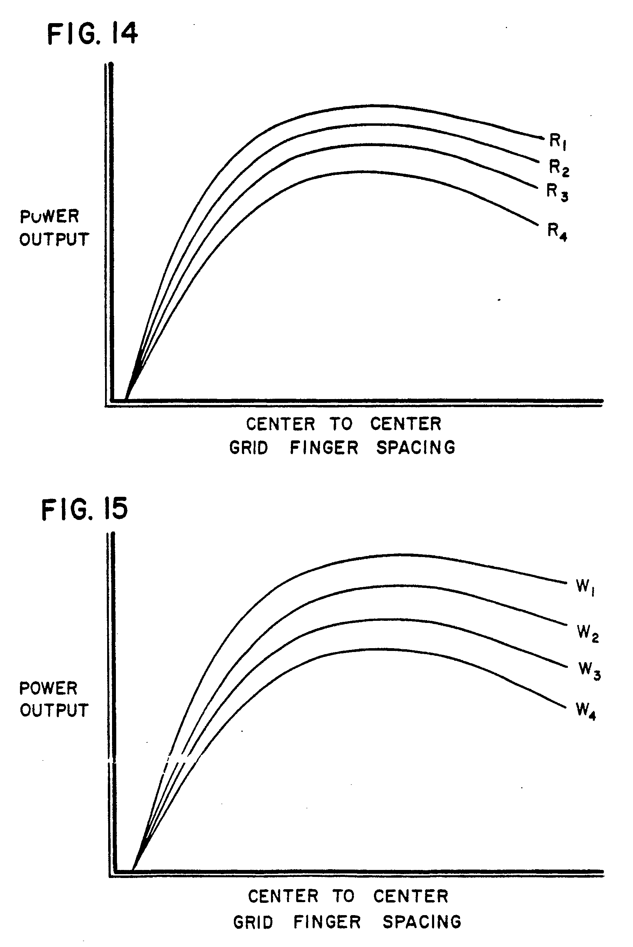

Referring to Figures 14 and 15, there are illustrated several graphs relating power output of photovoltaic devices to several variables, including center-to-center grid finger spacing, grid finger width and transparent conductive layer resistance. Such graphs are useful in optimizing the design of a photovoltaic device while designing the device to provide a desired degree of protection from defects (low resistance current paths) in the device.

Figure 14 is a graph that shows the relationship of photovoltaic device power output versus center-to-center grid finger spacing for different transparent conductive layer resistances and constant grid finger width. While the graph of Figure 14 illustrates that the lowest resistance conductive layer provides the greatest power output, such an arrangement also provides the least degree of protection from defects. Once the desired conductive layer resistance is determined, taking into account the protection provided by a higher resistance conductive layer, the grid finger spacing can be chosen. For a particular conductive layer resistance, there is an optimum center-to-center grid finger spacing that can easily be determined by reference to a graph as in Figure 14. As higher resistance conductive layers are utilized, proper center-to-center grid finger spacing becomes more critical, since the range of relatively practical center-to-center grid finger spacing becomes relatively narrow.

Figure 15 graphically illustrates the relationship of power output of a photovoltaic device versus center-to-center grid finger widths at constant conductive layer resistance. From this graph, it is apparent that the smallest grid finger width is optimum. However, the optimum center-to-center grid finger spacing depends on the grid finger width. Up to a limit, greater grid finger spacing provides increased power output since shadowing of the device is reduced. After an optimum point is reached, output power decreases for greater grid finger spacing.

## Claims

1.  A photovoltaic device (76) comprising an electrically conducting substrate (14), a semiconductor body (12) deposited on said substrate (14), a transparent, electrically conducting current collecting layer (22) disposed on said semiconductor body and a grid structure (30) in electrical contact with said current collecting layer (22) for collecting and conducting current generated by the device (76), said grid structure (30) including a busbar (34) electrically interconnected to a plurality of current collecting grid fingers (28) characterized in that said grid fingers (28) are resistively interconnected to said busbar (34) to have current carrying capacity not exceeding about five times the amount of current that can be produced by the area of device (76) from which a grid finger collects current.

2. The photovoltaic device of claim 1 characterized in that said grid structure includes a minor busbar (32) electrically interconnecting said grid fingers (28) to said busbar (34).

3. The photovoltaic device of claims 1 or 2 characterized in that said resistive interconnections (116) are destructible and electrically open when the current flowing through them exceeds a preselected amount.

4. The photovoltaic device of claim 3 characterized in that said resistive interconnections (116) are fusible links.

5. The photovoltaic device of claim 3 characterized in that an interconnection (116) opens when approximately 1.2 times the amount of current that can be produced by the area of the device from which current flows through the interconnection, flows through the interconnection.

6. The photovoltaic device of any one of claims 1, 2, or 3 characterized in that an electrical insulator (26) is disposed between said busbar (34) and current collecting layer (22).

7. The photovoltaic device of claim 6 characterized in that said insulator (26) is transparent.

8. The photovoltaic device of any one of claims 1, 2, 3, or 6 characterized in that said current collecting layer (22) has a sheet resistance exceeding 300 ohms per square.

9. The photovoltaic device of claim 8 characterized in that said current collecting layer has a sheet resistance of approximately 1000 ohms per square.

10. The photovoltaic device of any one of claims 1, 3, 6 or 8 characterized in that said grid fingers (96) are directly connected to said busbar (94), said grid fingers (96) are of varying lengths and the cross-sectional dimensions of said grid fingers are selected so that each of said grid fingers (96) has substantially the same resistance.

**Revendications**

1. Un dispositif photovoltaïque (76) comprenant un substrat électriquement conducteur (14), un corps semi-conducteur (12) déposé sur ledit substrat (14), une couche collectrice transparente, conduisant électriquement le courant (22), disposée sur ledit corps semi-conducteur et une structure de grille (30) en contact électrique avec ladite couche collectrice de courant (22) pour collecter et conduire un courant engendré par le dispositif (76), ladite structure de grille (30) comprenant une barre collectrice (34) reliée électriquement à plusieurs doigts (28) de grilles collectrices de courant, caractérisé en ce que lesdits doigts de grilles (28) sont reliés par une résistance à ladite barre collectrice (34) pour avoir une capacité de transport de courant qui ne dépasse pas environ cinq fois l'intensité de courent qui peut être produite par la surface du dispositif (76) à partir de laquelle un doigt de grille collecte du courant.

2. Le dispositif photovoltaïque selon la revendication 1 caractérisé en ce que ladite structure de grille comprend une barre collectrice mineure (32) reliant électriquement ------------lesdits doigts de grille (28) à ladite barre collectrice (34).

3. Le dispositif photovoltaïque selon les revendications 1 ou 2 caractérisé en ce que lesdites liaisons résistances (116) sont destructibles et ouvertes électriquement lorsque le courant qui les traverse dépasse une intensité choisie au préalable.

4. Le dispositif photovoltaïque selon la revendication 3 caractérisé en ce que lesdits liaisons résistantes (116) sont des liaisons par fusible.

5. Le dispositif photovoltaïque selon la revendication 3 caractérisé en ce qu'une liaison (116) s'ouvre lorsqu'il passe à travers la liaison environ 1,2 fois l'intensité de courant qui peut être produite par la zone du dispositif d'où vient le courant traversant la liaison.

6. Le dispositif photovoltaïque selon l'une quelconque des revendications 1, 2, ou 3 caractérisé en ce qu'un isolant électrique (26) est disposé entre ladite barre collectrice (34) et ladite couche collectrice de courant (22).

7. Le dispositif photovoltaïque selon la revendication 6 caractérisé en ce que ledit isolant (26) est transparent.

8. Le dispositif photovoltaïque selon l'une quelconque des revendications 1, 2, 3 ou 6 caractérisé en ce que ladite couche collectrice de courant (22) possède une résistance de couche dépassant 300 ohms par carré.

9. Le dispositif photovoltaïque selon la revendication 8 caractérisé en ce que ladite couche collectrice de courant possède une résistance de couche d'environ 1000 ohms par carré.

10. Le dispositif photovoltaïque selon l'une quelconque des revendications 1, 3, 6, ou 8 caractérisé en ce que lesdits doigts de grilles (96) sont directement reliés à ladite barre collectrice (94), lesdits doigts de grilles (96) sont de longueurs variables et les dimensions en section transversale desdits doigts de grilles sont choisies de telle manière que chacun desdits doigts de grilles (96) possède sensiblement la même résistance.

**Ansprüche**

1. Eine photovoltaische Vorrichtung (76) mit einem elektrisch leitenden Substrat (14), einem auf diesem Substrat (14) aufgebrachten Halbleiter-Körper (12), einer transparenten, elektrisch leitenden Schicht (22) auf dem Halbleiter-Körper und einer Gitter-Struktur (30) in elektrischem Kontakt mit der Stromsammelschicht (22) zum Sammeln und Ableiten des von der Vorrichtung (76) erzeugten Stroms, wobei die Gitter-Struktur (30) eine Stromsammelschiene (34) im elektrischen Kontakt mit einer Mehrzahl von Gitterfingern (28) aufweist, dadurch gekennzeichnet, daß diese Gitterfinger (28) mit der Stromsammelschiene (34) mit solchem Widerstand verbunden sind, daß sie eine Stromspeicherkapazität haben, die nicht die fünffache Menge Strom übersteigt, die von dem Bereich der Vorrichtung (76) erzeugt werden kann und von einem Gitterfinger gesammelt wird.

2. Die photovoltaische Vorrichtung gemäß Anspruch 1, dadurch gekennzeichnet, daß die Gitterstruktur eine kleinere Stromsammelschiene (32) aufweist, die diese Gitterfinger (28) mit der Stromsammelschiene (34) elektrisch verbindet.

3. Die photovoltaische Vorrichtung gemäß Anspruch 1 oder 2, dadurch gekennzeichnet, daß die Widerstandsverbindungen (116) zerstörbar ausgeführt sind und elektrisch geöffnet sind, wenn der sie durchfließende Strom eine vorgewählte Menge übersteigt.

4. Die photovoltaische Vorrichtung gemäß Anspruch 3, dadurch gekennzeichnet, daß diese Widerstandsverbindungen (116) schmelzbare Verbindungen sind.

5. Die photovoltaische Vorrichtung gemäß Anspruch 3, dadurch gekennzeichnet, daß die Verbindungen (116) sich öffnen, wenn etwa die 1,2-malige Strommenge durch die Verbindung fließt, die von dem Bereich der Vorrichtung hergestellt werden kann, von dem Stromfluß durch die Verbindung fließt.

6. Die photovoltaische Vorrichtung gemäß irgendeinem der Ansprüche 1, 2 oder 3, dadurch gekennzeichnet, daß eine elektrische Isolation (26) zwischen der Stromsammelschiene (34) und der Stromsammelschicht (22) angeordnet ist.

7. Die photovoltaische Vorrichtung gemäß Anspruch 6, dadurch gekennzeichnet, daß die Isolierung (26) transparent ist.

8. Die photovoltaische Vorrichtung gemäß irgendeinem der Ansprüche 1, 2, 3 oder 6, dadurch gekennzeichnet, daß die Stromsammelschicht (22) einen Schichtwiderstand oberhalb 300 Ohm pro Quadrat hat.

9. Die photovoltaische Vorrichtung gemäß Anspruch 8, dadurch gekennzeichnet, daß die Stromsammelschicht einen Schichtwiderstand von ungefähr 1000 Ohm pro Quadrat hat.

10. Die photovoltaische Vorrichtung gemäß irgendeinem der Ansprüche 1, 3, 6 oder 8, dadurch gekennzeichnet, daß die Gitterfinger (96) direkt mit der Stromsammelschiene (94) verbunden sind, die Gitterfinger (96) mit variierenden Längen ausgeführt sind und die Querschnittsdimension dieser Gitterfinger so ausgewählt ist, daß jeder dieser Gitterfinger (96) im wesentlichen den gleichen Widerstand aufweist.

FIG. 1

FIG. 2

FIG. 3

FIG. 4

FIG. 5

FIG. 6

FIG. 7

FIG. 8

FIG. 9

FIG. 10

FIG. 11

FIG. 12

# FIG. 13

## FIG. 14

POWER OUTPUT

R₁
R₂
R₃
R₄

CENTER TO CENTER
GRID FINGER SPACING

## FIG. 15

POWER OUTPUT

W₁
W₂
W₃
W₄

CENTER TO CENTER
GRID FINGER SPACING